# EUROPÄISCHE PATENTSCHRIFT

(11) **EP 1 297 346 B1**
(45) Veröffentlichungstag und Bekanntmachung des Hinweises auf die Patenterteilung: **22.09.2004**
(21) Anmeldenummer: 01915103.4
(22) Anmeldetag: 15.03.2001
(51) Int. Cl.: G01R 1/20, G01R 1/44

(54) **EINRICHTUNG ZUM MESSEN EINES DURCH EINE LEITERBAHN FLIESSENDEN ELEKTRISCHEN STROMS**
DEVICE FOR MEASURING AN ELECTRIC CURRENT THAT FLOWS THROUGH A STRIP CONDUCTOR
DISPOSITIF PERMETTANT DE MESURER UN COURANT ELECTRIQUE CIRCULANT A TRAVERS UNE PISTE CONDUCTRICE

(30) Priorität: 17.03.2000 DE 10013345
(43) Veröffentlichungstag der Anmeldung: 02.04.2003
(73) Patentinhaber: Sauer-Danfoss Holding ApS, 6430 Nordborg (DK)
(72) Erfinder: TRÜMPLER, Walter, 76227 Karlsruhe (DE); KOHNLE, Horst, 76229 Karlsruhe (DE); HINKEN, Reiner, 24866 Busdorf (DE)
(74) Vertreter: Nissen, Georg
(86) Internationale Anmeldenummer: PCT/DK2001/000173
(87) Internationale Veröffentlichungsnummer: WO 2001/069269

(56) Entgegenhaltungen:
- EP-A1- 0 265 076
- EP-A1- 0 500 976
- DE-B1- 2 114 466
- US-A- 4 713 607
- US-A- 6 028 426

## Beschreibung

Die Erfindung bezieht sich auf eine Einrichtung zum Messen eines durch eine Leiterbahn fließenden elektrischen Stroms, mit einem sich in Stromflußrichtung längs und in der Nähe eines Meßabschnitts der Leiterbahn erstreckenden geradlinigen und weitgehend stromlosen Meßleiter, dessen eines Ende direkt mit dem einen Ende des Meßabschnitts elektrisch verbunden und dessen anderes Ende mit einem ersten Meßwertabgriff versehen ist, und mit einem zweiten Meßwertabgriff, der elektrisch mit dem anderen Ende des Meßabschnitts verbunden ist, wobei der zweite Meßwertabgriff direkt mit dem Meßabschnitt verbunden ist, so daß an den Meßwertabgriffen eine Spannung als Maß für den zu messenden Strom abgegriffen wird.

Bei einer bekannten Meßeinrichtung (DE 33 24 224 A1, Fig. 4) ist die Leiterbahn U-förmig gebogen und auf der Außenseite jedes Schenkels der U-förmigen Leiterbahn jeweils ein Meßleiter angebracht, dessen eines Ende jeweils mit einem der freien Schenkelenden elektrisch verbunden ist. Eine solche Leiterbahn läßt sich nicht auf einer isolierenden Trägerplatte, wie die Leiterbahnen einer gedruckten Schaltung, aufbringen. Darüber hinaus wird über den einen Meßleiter ein Teilstrom aus der Leiterbahn abgezweigt und über einen Gegenkoppplungswiderstand eines Operationsverstärkers sowie Spannungsquellen dem anderen Meßleiter wieder zugeführt. Am Ausgang des Operationsverstärkers wird die Meßspannung abgenommen, die dann dem Gegenkopplungswiderstand und dem Verhältnis des Widerstands der Leiterbahn sowie der Summe dieses Widerstands und des Widerstands der Meßleiter proportional ist. Ein Operationsverstärker kann typisch bis zu 10 mA aufbringen. Der zu messende Strom in der Leiterbahn kann jedoch bis zu 1000 A betragen. Daraus ergibt sich schon bei einem zu messenden Strom von 100 A ein Meßleiterquerschnitt, der im Verhältnis von 10.000 zu dem der Leiterbahn steht. Um genau zu messen, müßte dieses extreme Querschnittsverhältnis auch noch mit einer Genauigkeit von wenigen Prozent ausgeführt sein. Dies ist praktisch nicht realisierbar, wenn die Leiterbahn nur die übliche Breite von einigen Millimetern hat. Der Querschnitt der Meßleiter wäre zu klein und ergäbe keinen genau definierten Wert, wie er für eine genaue Messung erforderlich ist. Darüber hinaus sind der Gegenkopplungswiderstand und zusätzliche Spannungsquellen aufwendig.

Aus der EP 0 408 136 B1 ist eine integrierte Schaltung (IC) bekannt, bei der eine Strommessung intern im IC an einer Leiterbahn erfolgt, die über eine bekannte Strecke einen bekannten ohmschen Widerstand hat. Die Leiterbahn ist durch einen Schlitz in zwei Teilströme geteilt, und an zwei Meßpunkten beiderseits der Leiterbahn wird ein Spannungsabfall als Maß für den Strom abgegriffen.

Gegenüber der EP 0 408 136 B1 ist es eine Aufgabe der Erfindung, eine Meßeinrichtung anzugeben, bei der die Maße von Leiterbahn und Meßleiter freizügiger wählbar sind, insbesondere eine herkömmliche Leiterbahn vorgesehen sein kann, und deren Aufwand bei hoher Meßgenauigkeit, ohne daß durch induktive Spannungsabfälle am Meßabschnitt Meßfehler entstehen, kleiner ist.

Diese Aufgabe ist dadurch gelöst, daß der Meßabschnitt geradlinig ist, daß der zweite Meßwertabgriff direkt mit dem Meßabschnitt verbunden ist, daß der Meßleiter weitgehend stromlos ist und daß an den Meßwertabgriffen eine Spannung als Maß für den zu messenden Strom abgegriffen wird.

Bei dieser Lösung wird praktisch stromlos gemessen. Es kann eine herkömmliche geradlinige Leiterbahn üblicher Abmessungen verwendet werden. Das Querschnittsverhältnis von Leiterbahn und Meßleiter kann auch bei Starkstrom in weiten Grenzen variiert werden. Der Aufwand ist geringer. Dennoch bewirken im Meßabschnitt auftretende induktive Spannungsabfälle praktisch keinen Meßfehler.

Vorzugsweise erstreckt sich der Meßleiter bis in unmittelbare Nähe der Verbindungsstelle von Meßabschnitt und zweitem Meßwertabgriff. Dementsprechend ist die durch einen pulsierenden Strom, der durch die Leiterbahn fließt, in dem Meßleiter induzierte Spannung um so größer, so daß ein induktiver Spannungsabfall in dem Meßabschnitt um so genauer ausgeglichen wird.

Aus der EP 0 265 076 A ist eine Einrichtung der eingangs genannten Art bekannt, in dem ein durch eine Leiterbahn fließender elektrischer Strom gemessen wird, mit einem sich in Stromflußrichtung längs und in Nähe eines geradlinigen Meßabschnitts der Leiterbahn erstreckenden Meßleiter, dessen eines Ende direkt mit dem einen Ende des Meßabschnitts elektrisch verbunden und dessen andres Ende mit einem ersten Meßwertabgriff versehen ist, und mit einem zweiten Meßwertabgriff, der elektrisch mit dem anderen Ende des Messabschnitts verbunden ist, wobei der zweite Meßwertabgriff direkt mit dem Meßabschnitt verbunden ist und an den Messwertabgriffen eine Spannung als Maß für den zu messenden Strom abgegriffen wird.

In einer solchen Einrichtung kann es vorkommen, daß eine Spannung in dem Meßleiter durch Wirbelströme in einer der Leiterbahn tragenden Trägerplatte, z.B. einer Kupferplatte, induziert wird, wodurch der Meßwert gefälscht werden kann. Gegenüber der EP 0 265 076 A liegt der Erfindung daher die Aufgabe zugrunde, eine Meßeinrichtung anzugeben, in der keine oder nur eine geringere Spannung in dem Meßleiter durch Wirbelströme in einer der Leiterbahn tragenden Trägerplatte induziert wird, um so zu erreichen, daß der Meßwert kaum oder gar nicht gefälscht wird. Ferner ist es die Aufgabe der Erfindung, eine Meßeinrichtung anzugeben, die in ihrer seitlichen Ausdehnung kleiner ausgebildet werden kann als herkömmliche Einrichtungen wie z.B. die, die aus der EP 0 265 076 bekannt ist.

Erfindungsgemäß wird dies dadurch erreicht, daß der Meßleiter außerhalb der Ebene der Leiterbahn aufgebracht ist, und daß der Meßleiter durch eine Leitung mit der Leiterbahn elektrisch verbunden und im übrigen in elektrischer Isolation von der Leiterbahn aufgebracht ist. In einer Ausführung kann dafür gesorgt sein, daß der Meßleiter auf einem auf der Leiterbahn befestigten Isolator aufgebracht ist. Die Leiterbahn kann in an sich bekannter Weise über eine wärmeleitende elektrisch isolierende Schicht auf einer Kupferplatte aufgebracht sein. Bei dieser Lösung dienen die Kupferplatte und die auf ihr aufgebrachte wärmeleitende, jedoch elektrisch isolierende Schicht einerseits als Substrat für die Leiterbahn und den Meßleiter sowie weiterer elektrischer Bauelemente und andererseits gleichzeitig zur Ableitung von Wärme aus den elektrischen Bauelementen und der Leiterbahn. Hierbei können in der Kupferplatte durch einen in der Leiterbahn fließenden Wechselstrom oder Rechteckstrom induzierte Wirbelströme zwar auch eine Spannung in dem Meßleiter induzieren. Da der Meßleiter in diesem Falle jedoch nicht in derselben Ebene wie die Leiterbahn liegt, sondern einen etwas größeren Abstand von der Kupferplatte hat, der der Dicke des Isolators entspricht, wird durch die Wirbelströme allenfalls eine sehr geringe Spannung in dem Meßleiter induziert, die den Meßwert kaum verfälscht.

Der Isolator besteht vorzugsweise aus Keramik. Dieses Material ist besonders gut wärmeleitend und elektrisch isolierend. Gleichzeitig können die Keramik und das Material der auf der Kupferplatte aufgebrachten Isolierschicht etwa den gleichen Wärmeausdehnungskoeffizienten haben.

Um den Isolator auf der Leiterbahn zu befestigen, ist er vorzugsweise auf seiner Unterseite mit einer Kupferbeschichtung versehen, die mit der Leiterbahn verlötet ist.

Eine alternative Ausführung kann darin bestehen, daß der Meßleiter von einer Isolierschicht umgeben ist. Auch hierbei ergibt sich ein größerer Abstand zwischen dem Meßleiter und einer Trägerplatte aus Kupfer, auf der die Leiterbahn über eine elektrisch isolierende Schicht befestigt ist.

Eine vorteilhafte Weiterbildung besteht darin, daß in der Nähe der Leiterbahn ein Temperaturfühler angeordnet ist, der mit einer Steuervorrichtung eines Leistungsteils verbunden ist, die den Leistungsteil in Abhängigkeit von einem Meßwert eines Verbraucherstroms steuert und mit einem Speicher in Austauschverbindung steht, daß ein Korrekturfaktor, der der Abweichung des ohmschen Widerstands des Meßabschnitts von einem vorbestimmten Nennwert entspricht, im Speicher gespeichert ist, und daß die Steuervorrichtung jeden Meßwert des durch die Leiterbahn fließenden Verbraucherstroms mit dem Korrekturfaktor multipliziert. Auf diese Weise werden selbsttätig Meßfehler durch eine vor der Inbetriebnahme mittels des durch die Leiterbahn geleiteten Stroms vorbekannter Stärke durchgeführte Testmessung dadurch ausgeglichen, daß aus dem Testmeßergebnis der Korrekturfaktor ermittelt und im Speicher abgelegt und während des Betriebs durch die Steuervorrichtung aus dem Speicher abgerufen und zur Korrektur der während des Betriebs durchgeführten Strommessungen herangezogen wird.

Der Korrekturfaktor kann die Abhängigkeit des ohmschen Widerstands des Meßabschnitts von einer vorbekannten Herstellungs-Maßtoleranz des Querschnitts des Meßabschnitts berücksichtigen.

Ein zweiter Korrekturfaktor kann die Abhängigkeit des ohmschen Widerstands des Meßabschnitts von der Temperatur berücksichtigen.

Bei einem puliserenden, eine Welligkeit aufweisenden Strom wird der Meßwert vorzugsweise während einer Impulsflanke, vorzugsweise in deren Mitte, abgetastet. Dadurch wird unmittelbar nur die Grundwelle gemessen und die Stromwelligkeit im Meßergebnis weitgehend ausgeblendet.

Die Erfindung und ihre Weiterbildungen werden nachstehend anhand der beiliegenden Zeichnungen bevorzugter Ausführungsbeispiele näher beschrieben. Hierin zeigen:
- Fig. 1: ein Ersatzschaltbild einer Leiterbahn und eines Meßabschnitts zum Messen eines durch die Leiterbahn fließenden Stroms durch Abgreifen einer Spannung an dem Meßabschnitt, mit einem angeschlossenen Spannungsverstärker für die abgegriffene Spannung,
- Fig. 2: einen Ausschnitt einer Leiterbahn mit einem Ausführungsbeispiel eines Meßabschnitts,
- Fig. 3: einen Ausschnitt einer Leiterbahn mit einem zweiten Ausführungsbeispiel eines Meßabschnitts und
- Fig. 4: ein Blockschaltbild eines Steuergeräts für einen Verbraucher in Form eines Asynchronmotors mit einem "intelligenten" Leistungsmodul, in dem Ströme in Leiterbahnen gemäß einem der Ausführungsbeispiele nach den Fig. 1 bis 3 gemessen werden können.

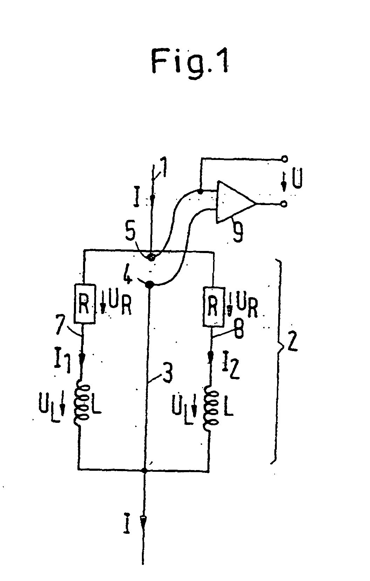

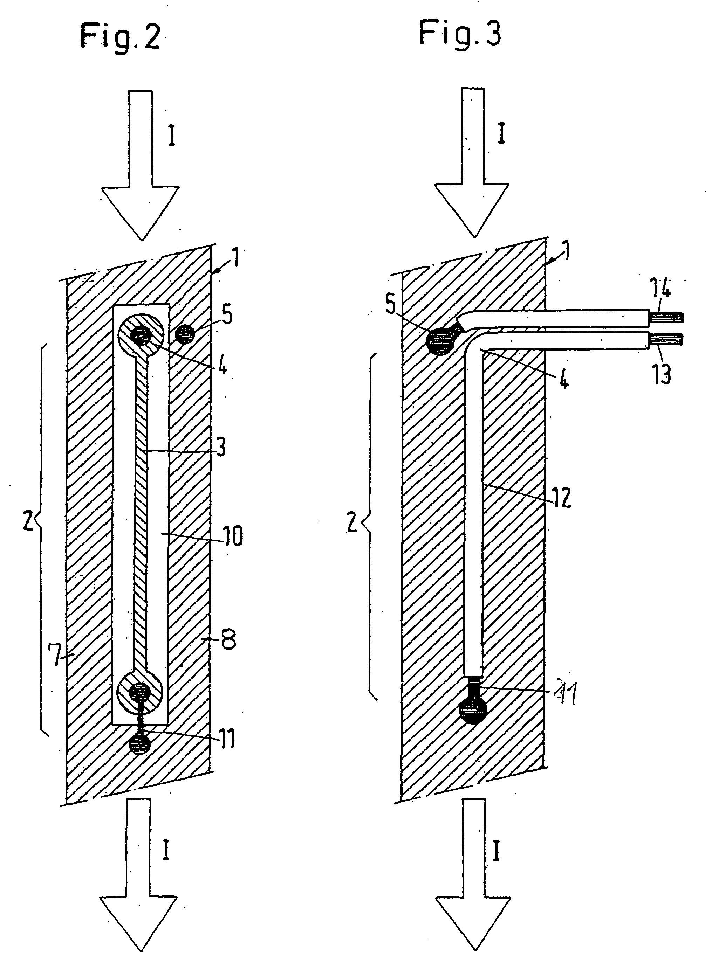

Nach Fig. 1 und 2 ist zum Messen eines durch eine langgestreckte Leiterbahn 1 in einem in Fig. 1 und 2, nicht dargestellten "intelligenten" Leistungsmodul, das auch als Intelligent Power Module (IPM) bezeichnet wird, fließenden elektrischen Stroms I ein sich in Stromflußrichtung längs und in der Nähe eines geradlinigen Meßabschnitts 2 der Leiterbahn 1, gegenüber dem Meßabschnitt 2 auf seinen beiden Seiten elektrisch isoliert erstreckender Meßleiter 3 vorgesehen. Der Meßleiter 3 liegt in einer zur Ebene des Meßabschnitts 2 senkrechten, weitgehend in der Längsmitte des Meßabschnitts 2 stehenden Ebene symmetrisch zu dieser senkrechten Ebene. Das eine Ende des Meßleiters 3 ist direkt mit dem einen Ende des Meßabschnitts 2 elektrisch verbunden. Das andere Ende des Meßleiters 3 ist mit einem ersten Meßwertabgriff 4 versehen. Das mit dem ersten Meßwertabgriff 4 versehene Ende des Meßleiters 3 ist mithin über den Meßleiter 3 mit der Leiterbahn 1 verbunden. Ein zweiter Meßwertabgriff 5 ist direkt mit dem anderen Ende des Meßabschnitts 2 elektrisch verbunden. Dieses andere Ende des Meßabschnitts 2 liegt in Stromflußrichtung vor dem zuerst erwähnten einen Ende des Meßabschnitts 2. Die Richtung des Stroms I kann aber auch umgekehrt zu der dargestellten gewählt sein. An den Meßwertabgriffen 4, 5 wird eine Spannung U als Maß für den zu messenden Strom über einen Meßverstärker 9 (Fig. 2) abgegriffen, wobei der Meßleiter 3 weitgehend stromlos ist.

Der Meßleiter 3 erstreckt sich bis in unmittelbare Nähe der Verbindungsstelle von Meßabschnitt 2 und zweitem Meßwertabgriff 5. Die Meßwertabgriffe 4, 5 müssen nicht, in bezug auf die Stromflußrichtung, seitlich nebeneinander liegen. Vielmehr können sie auch in Stromflußrichtung hintereinander liegen.

Dadurch ist der Meßleiter 3 seitlich gegenüber der Leiterbahn 1 bzw. den Leiterbahnabschnitten 7 und 8 elektrisch isoliert und mithin nur mit seinem einen Ende durch eine Leitung 11 mit der Leiterbahn elektrisch verbunden. Der durch die Leiterbahn 1 fließende Strom I kann bis zu 1000 A betragen.

Wie Fig. 1 zeigt, haben die Leiterbahnabschnitte 7 und 8 gleich große ohmsche Widerstände R und gegenüber hochfrequenten Strömen I, z.B. sinusförmigen Wechselströmen oder impulsartigen Strömen mit steilen Flanken, insbesondere Rechteckimpulsen, gleich große Induktivitäten L, die zusammen etwa 10 bis 20 nH betragen.

Wenn es sich bei dem Strom I um einen Gleichstrom handelt, handelt es sich bei den Teilströmen I₁ und I₂ ebenfalls um Gleichströme, die einander gleich und gleich dem halben Strom I sind. Die Teilströme I₁ und I₂ erzeugen dann nur an den ohmschen Widerständen R einen Spannungsabfall U_{R}, der mithin proportional dem Strom I ist und als Maß für den Strom I über den (gegenüber den Widerständen R einen hochohmigen Eingangswiderstand aufweisenden) Verstärker 9 als Meßspannung U abgenommen wird.

Im Falle eines hochfrequenten sinusförmigen Wechselstroms I oder eines pulsierenden Stroms I mit steilen Flanken ergibt sich jedoch auch ein Spannungsabfall U_{L} an den Eigeninduktivitäten L der Leiterbahnabschnitte 7 und 8. Diese induktiven Spannungsabfälle U_{L} würden das Meßergebnis verfälschen, wenn die Meßspannung unmittelbar an den beiden Enden des Meßabschnitts 2 abgegriffen würde. Im vorliegenden Falle wird die Meßspannung jedoch am freien Ende des Meßleiters 3 und an dem in Richtung des Stroms I vorn (stromoberhalb) liegenden Ende des Meßabschnitts 2 zwischen den Meßwertabgriffen 4, 5 abgegriffen. Dadurch wird ein Meßfehler aufgrund der induktiven Spannungsabfälle U_{L} an den Induktivitäten L vermieden, weil die Magnetfelder der Teilströme I₁ und I₂ mit dem Meßleiter 3 verkettet bzw. transformatorisch gekoppelt sind und in dem Meßleiter 3 ebenfalls Spannungen induzieren, deren Summe jeweils etwa gleich einem der induktiven Spannungsabfälle U_{L} an den Induktivitäten L ist. Ferner sind die im Meßleiter 3 induzierten Spannungen jeweils den induktiven Spannungsabfällen U_{L} in den Maschen 3, 7 und 5 bzw. 3, 8 und 5 entgegengerichtet, so daß sie die Spannungsabfälle U_{L} weitgehend ausgleichen und mithin auch bei sich zeitlich rasch änderndem Strom I nur der Spannungsabfall U_{R} als Maß für den Strom I gemessen wird, wobei durch den Meßleiter 3 praktisch kein Strom fließt.

Die Leiterbahn 1 ist als Teil eines Leistungsmoduls über eine elektrisch isolierende Schicht auf einem Träger in Form einer Kupferplatte aufgebracht, auf der sich auch die übrigen Leistungsbauteile des Leistungsmoduls befinden, wobei die elektrisch isolierende Schicht ebenso wie die Kupferplatte gut wärmeleitend ist, um die Verlustwärme der Bauteile, einschließlich einer etwaigen Verlustwärme der Leiterbahn 1, abführen zu können. Die elektrisch isolierende Schicht besteht daher vorzugsweise aus Keramik, die ebenfalls gut wärmeleitend ist. Hierbei ist die Leiterbahn nach dem DCB-Verfahren (DCB = Direct Copper Bonding) auf der Kupferplatte befestigt.

Bei dem Ausführungsbeispiel nach Fig. 2 ist ein elektrisch isolierender, jedoch wärmeleitender Isolator 10 in Form eines Streifens in der Längsmitte der Leiterbahn 1 auf dieser aufgebracht, wobei die Unterseite des Isolators 10 mit einer Kupferschicht versehen und die Kupferschicht mit der Leiterbahn 1 verlötet ist. Auf der Oberseite des wiederum aus Keramik bestehenden Isolators 10 ist der Meßleiter 3 vorzugsweise ebenfalls mit dem DCB-Verfahren aufgebracht, wobei er in diesem Falle nicht einstückig mit der Leiterbahn 1 ausgebildet, sondern über die Leitung 11 mit dem einen Ende des Meßabschnitts 2 verbunden ist. Die Meßwertabgriffe 4 und 5 liegen wiederum in der Nähe des in Stromflußrichtung vorderen Endes des Meßabschnitts 2. Auch bei diesem Ausführungsbeispiel ist die Leiterbahn 1 über eine wärmeleitende elektrisch isolierende Schicht, vorzugsweise aus Keramik im DCB-Verfahren, auf einer der Wärmeableitung dienenden Kupferplatte aufgebracht.

Dieses Ausführungsbeispiel hat gegenüber bekannten Einrichtungen den Vorteil, daß der Meßleiter 3 aufgrund des zwischengeschalteten Isolators 10 einen etwas größeren Abstand von der den Träger bildenden Kupferplatte hat, so daß das Magnetfeld von Wirbelströmen, die durch einen starken Wechselstrom oder pulsierenden Strom I in der den Träger bildenden Kupferplatte induziert werden, eine geringere Spannung in dem Meßleiter 3 induziert, die die durch den Strom I in dem Meßleiter 3 induzierte Kompensationsspannung beeinflussen würde, insbesondere dahingehend, daß die Flankensteilheit des Stroms I abnehmen und es mithin zu lange dauern würde, bis die zu messende Spannung stabil ist, um eine korrekte Messung vornehmen zu können. Durch den größeren Abstand des Meßleiters 3 von der Kupferplatte wird die Beeinträchtigung der Spannung im Meßleiter 3 durch die Wirbelströme weitgehend beseitigt. Dennoch ist der Abstand des Meßleiters 3 von der Leiterbahn 1 noch hinreichend gering gewählt, daß weiterhin eine Kompensationsspannung im Meßleiter 3 induziert wird.

Das Ausführungsbeispiel nach Fig. 3 unterscheidet sich im Prinzip von dem nach Fig. 2 nur dadurch, daß der Meßleiter 3 nicht auf einem streifenförmigen Isolator liegt, sondern vollständig von einer Isolierschicht 12 umgeben ist, die jedoch den gleichen Zweck wie der Isolator 10 nach Fig. 2 hat und auf der Leiterbahn 1 befestigt ist. Der Meßleiter nach Fig. 3 kann in diesem Falle ein im Querschnitt runder Draht sein, im Gegensatz zu den flachen Meßleitern 3 bei den vorgehenden Ausführungsbeispielen. Mit den Meßwertabgriffen 4 und 5 verbundene Anschlußleitungen 13 und 14, die mit dem Verstärker 9 verbunden sind, erstrecken sich etwa im rechten Winkel zur Längsrichtung der Leiterbahn 1, um zu vermeiden, daß in diesen Anschlußleitungen 13 und 14 durch einen sich ändernden Strom I die Meßspannung verfälschende Spannungen induziert werden.

Auch bei den übrigen Ausführungsbeispielen nach den Fig. 1 und 2 sollten derartige Anschlußleitungen, wie die Anschlußleitungen 13 und 14 nach Fig. 3 etwa im rechten Winkel zur Längsrichtung der Leiterbahn 1 verlaufen.

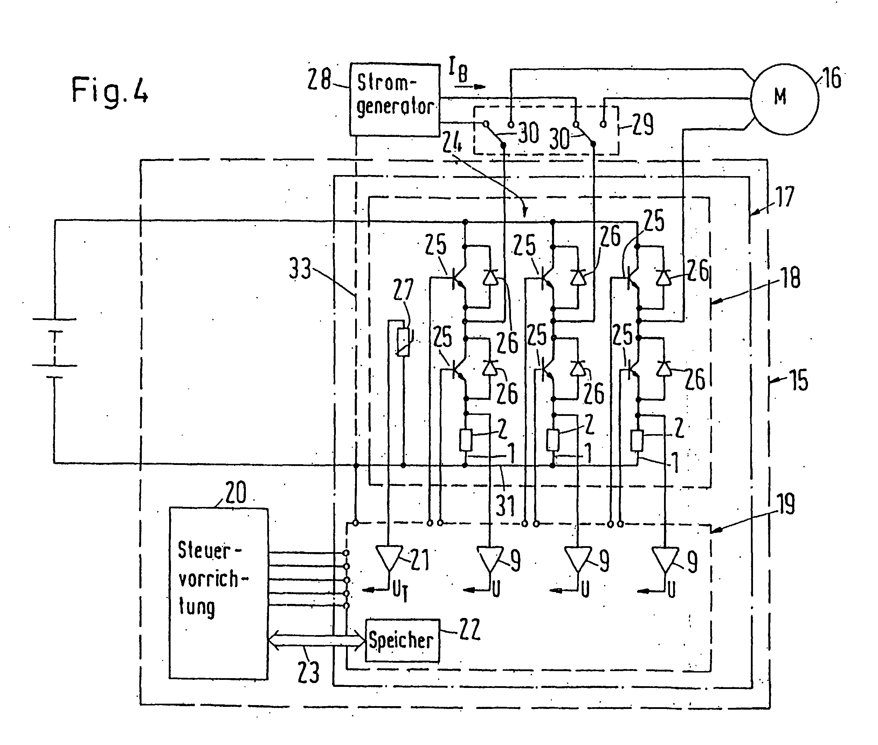

Fig. 4 stellt schematisch in Form eines Blockschaltbilds ein Steuergerät 15 für einen mit dreiphasigem Wechselstrom betriebenen Verbraucher 16 dar, das ein "intelligentes" Leistungsmodul 17, auch IPM (Intelligent Power Modul) genannt, aufweist.

Das Leistungsmodul 17 enthält einen Leistungsteil 18 sowie eine Steuer- und Meßeinheit 19. Sodann ist das Leistungsmodul 17 über Einzelleitungen und Anschlüsse mit einer Steuervorrichtung 20 verbunden, die einen nicht dargestellten Mikroprozessor aufweist. Die Steuer- und Meßeinheit 19 enthält Meßverstärker 9 und 21 und nicht dargestellte Treiberstufen für den Leistungsteil 18, die jeweils über die Einzelleitungen mit der Steuervorrichtung 20 verbunden sind, sowie einen Speicher 22, hier einem EEPROM, der über einen Datenbus 23 mit der Steuervorrichtung 20 in Austauschverbindung steht. Alternativ zu dem dargestellten Ausführungsbeispiel kann die Steuervorrichtung 20 auch in der Steuerund Meßeinheit 19 und damit im Leistungsmodul 17 angeordnet sein.

Der Leistungsteil 18 ist über eine elektrisch isolierende, jedoch wärmeleitende Schicht, vorzugsweise aus Keramik, auf einem Träger in Form einer Kupferplatte, die der Wärmeabfuhr dient, befestigt.

Der Leistungsteil 18 enthält einen Stromrichter 24 mit Leistungsschaltelementen 25 in Form von Transistoren und mit Freilaufdioden 26 zur Steuerung des Betriebs des Verbrauchers 16, hier eines Asynchronmotors. Ferner enthält der Leistungsteil 18 einen Meßabschnitt 2 gemäß einem der Ausführungsbeispiele nach den Fig. 1 bis 3 in jeder den Strom des Leistungsteils 18 und damit des Verbrauchers 16 führenden Versorgungsleitung in Form einer Leiterbahn 1 in jeder der drei Phasen des Stromrichters 24, hier eines Wechselrichters. Die Meßabschnitte 2 sind über jeweils einen der Meßverstärker 9 für die an ihnen abgegriffene Spannung mit der Steuervorrichtung 20 verbunden. Ferner enthält der Leistungsteil 18 einen Temperaturfühler 27, hier einen temperaturabhängigen Widerstand, der die Temperatur der Kupferplatte und damit auch die jeder Leiterbahn 1 erfaßt und dessen Meßwerte als Meßspannung U_{T} ebenfalls in die Steuervorrichtung 20 übertragen werden. Statt mehrerer Meßabschnitte 2, die jeweils in einer der Leiterbahnen 1 liegen, kann auch nur ein Meßabschnitt 2 vorgesehen sein, der in einer gemeinsamen Versorgungsleitung des Stromrichters 24 oder eines einphasigen Verbrauchers liegt. In beiden Fällen erfaßt der bzw. jeder Meßabschnitt 2 ein Maß des durch wenigstens eine Versorgungsleitung fließenden Verbraucherstroms.

Sodann sind ein Stromgenerator 28 und ein Umschalter 29 außerhalb, wie dargestellt, oder innerhalb des Steuergeräts 15 vorgesehen. Der Stromgenerator 28 erzeugt einen Strom I_{B} vorbestimmter Stärke. Der Umschalter 29 hat zwei bewegliche Kontakte 30, deren Wurzel jeweils mit einem der Ausgänge zweier Phasen, d.h. den Verbindungspunkten jeweils zweier in Reihe geschalteter Leistungsschaltelemente 25, verbunden ist.

Der Stromgenerator 28 und der Umschalter 29 dienen der Korrektur von Fehlern bei der Messung des während des Betriebs als Maß für den jeweiligen Strom am Meßabschnitt 2 abgegriffenen und durch den betreffenden Verstärker 9 verstärkten Meßspannung U. Ein solcher Meßfehler kann dadurch entstehen, daß der ohmsche Widerstand des Meßabschnitts 2 der jeweiligen Leiterbahn 1 entsprechend der jeweiligen Herstellungs-Maßtoleranz, d.h. unterschiedlicher Breite, Dicke und Länge der Meßstrecke, und wegen des Temperaturkoeffizienten des Widerstands des Materials der Leiterbahn 1 bei sich ändernder Temperatur des Meßabschnitts 2 sowie aufgrund von Offsetfehlern in der Verstärkerschaltung unterschiedlich sein kann.

Um derartige Meßfehler auszugleichen, wird bei einem Leistungsmodul 17 mit geeichten Meßabschnitten 2 der Stromgenerator 28 angeschaltet. Gleichzeitig werden die über die Meßabschnitte 2 mit der Rückleitung 31 und mit den Kontakten 30 verbundenen Schaltelemente 25 durch die Steuervorrichtung 28 eingeschaltet bzw. durchgesteuert, so daß der bekannte Strom I_{B} des Stromgenerators 28 über den einen Kontakt 30, das in Reihe liegende Schaltelement 25, den mit diesem in Reihe liegenden Meßabschnitten 2, die Rückleitung 31, einen weiteren Meßabschnitt 2, die mit diesem in Reihe liegende Diode 26 und den anderen Kontakt 30 zum Stromgenerator 28 zurückfließt. Die bei dieser Eichmessung gemessenen Spannungen U und die gleichzeitig durch den Temperaturfühler 27 gemessene Temperatur werden im Speicher des Mikroprozessors der Steuervorrichtung 20 gespeichert. Bei jedem weiteren Leistungsmodul 17 einer Serie wird dann wiederum vor dessen Inbetriebnahme der Stromgenerator 28 an dem Leistungsmodul 17 angeschaltet. Sodann werden die Werte der Meßspannungen U und die durch den Temperaturfühler 27 hierbei gemessene Temperatur in den Speicher des Mikroprozessors der Steuervorrichtung 20 übertragen. Aus einem Vergleich der Eichmeßwerte mit den Meßwerten des neuen Leistungsmoduls 17 wird dann ein Korrekturfaktor K_{H} durch den Mikroprozessor der Steuervorrichtung 20 ermittelt, der die Abweichung der Eichmeßwerte von den Meßwerten des neuen Leistungsmosuls 17 berücksichtigt. Dieser Korrekturfaktor K_{H} wird aus der Steuervorrichtung 20 in den Speicher 22 übertragen. Desgleichen wird ein die Temperaturabhängigkeit der Meßabschnitte 2 berücksichtigender Temperaturkorrekturfaktor K_{T}, der zuvor ermittelt und im Speicher des Mikroprozessors der Steuervorrichtung 20 gespeichert wurde, in den Speicher 22 übertragen. Vorzugsweise wird der Temperaturkorrekturfaktor jedoch laufend während des Betriebs ermittelt und im Speicher 22 abgelegt. Während des Betriebs wird der Strommeßwert U mit den Korrekturfaktoren K_{H} und K_{T} multipliziert, nachdem diese Korrekturfaktoren zuvor aus dem Speicher 22 in die Steuervorrichtung 20 abgerufen wurden. Der Stromgenerator 28 und der Umschalter 29 können, entgegen der Darstellung, auch im Steuergerät 15 eingebaut sein. Um eine etwaige Offset-Spannung der Meßverstärker 9 zu kompensieren, kann diese wiederholt in Betriebspausen gemessen und während des Betriebs zur Korrektur benutzt werden.

Die korrigierten Meßspannungen U sind dann unabhängig von Temperaturänderungen und Herstellungs-Maßtoleranzen der Meßstrecken 2 und werden zur Steuerung des Stromrichters 24 durch die Steuervorrichtung 20 über die Steuer- und Meßeinheit 19 herangezogen.

Zusätzlich wird der korrigierte Meßwert des Stroms aus dem Leistungsmodul 17 herausgeführt und bei Bedarf auf einer Anzeigevorrichtung angezeigt.

Statt den bekannten Strom I_{B} mittels des zweipoligen Umschalters 29 über einen Stromkreis zu leiten, der zwei Schaltelemente 25 und zwei Meßstrecken 2 enthält, ist es auch möglich, einen Stromgenerator 28 mit nur einem Ausgang und einer mit der gemeinsamen Rückleitung 31 aller Stromrichterzweige verbundenen Rückleitung 33 sowie einen Umschalter zu verwenden, der den Ausgang des Stromgenerators 28 bei der Eichung bzw. Fehlerkorrektur mit allen Ausgängen des Stromrichters 24 verbindet. Die direkt mit den Meßstrecken 2 verbundenen Schaltelemente 25 können dann nacheinander durch die Steuervorrichtung 20 eingeschaltet werden. Während des Betriebs, nach einer Fehlerkorrektur, würde der Umschalter dann den Stromgenerator 28 vom Stromrichter 24 trennen und den Verbraucher 16 anschließen.

Wenn die Stromstärke in der üblichen Weise durch eine Pulsdauermodulation über den Stromrichter 28 geändert wird, weist der pulsierende Strom eine große Welligkeit auf. Zweckmäßigerweise erfolgt daher die Abtastung des Meßwerts durch die Steuervorrichtung 20 schon während der Anstiegsflanke des Stroms, vorzugsweise in deren Mitte. Dadurch wird nur die Grundwelle gemessen und die Stromwelligkeit aus dem Meßergebnis ausgeblendet.

In dem Speicher 22 können neben Speicherabschnitten für die Meßwerte von Temperatur und Strom sowie den Korrekturfaktor weitere Speicherabschnitte für Kenndaten, wie sie auf Typenschildern angegeben werden, Fertigungsdaten, wie Losnummern, Daten von Komponenten, Antriebsparameter, Betriebsereignisse, wie Daten extremer Lastsituationen und Störungsdaten, wie Defekte, enthalten sein. Das hat bei der Herstellung den Vorteil, daß derselbe Speicher 22 bei verschiedenen Leistungsteilen eingesetzt werden kann. Ferner kann für Reparaturzwecke ein "Logbuch" über Reparaturvorgänge und Grenzwertüberschreitungen gespeichert werden. Um die Betriebssicherheit des Moduls zu erhöhen, sind Betriebsparameter, die normalerweise in dem Speicher der Steuervorrichtung 20 gespeichert sind, zusätzlich im Speicher 22 gespeichert. So kann bei einer Auswechselung der Steuervorrichtung 20 die neue Steuervorrichtung die alten Betriebsparameter aus dem Speicher 22 übernehmen.

## Patentansprüche

1. Einrichtung zum Messen eines durch eine Leiterbahn (1) fließenden elektrischen Stroms (I), mit einem sich in Stromflußrichtung längs und in der Nähe eines geradlinigen Meßabschnitts (2) der Leiterbahn erstreckenden und weitgehend stromlosen Meßleiter (3), dessen eines Ende direkt mit dem einen Ende des Meßabschnitts (2) elektrisch verbunden und dessen anderes Ende mit einem ersten Meßwertabgriff (4) versehen ist, und mit einem zweiten Meßwertabgriff (5), der elektrisch mit dem anderen Ende des Meßabschnitts (2) verbunden ist, wobei der zweite Meßwertabgriff (5) direkt mit dem Meßabschnitt (2) verbunden ist, so daß an den Meßwertabgriffen (4, 5) eine Spannung (U) als Maß für den zu messenden Strom (I) abgegriffen wird, **dadurch gekennzeichnet, daß** der Meßleiter (3) außerhalb der Ebene der Leiterbahn (1) aufgebracht ist; und daß der Meßleiter (3) durch eine Leitung (11) mit der Leiterbahn (1) elektrisch verbunden und im übrigen in elektrischer Isolation von der Leiterbahn aufgebracht ist.

2. Einrichtung nach Anspruch 1, **dadurch gekennzeichnet, daß** sich der Meßleiter (3) bis in unmittelbare Nähe der Verbindungsstelle von Meßabschnitt (2) und zweitem Meßwertabgriff (5) erstreckt.

3. Einrichtung nach Anspruch 1 oder 2, **dadurch gekennzeichnet, daß** der Meßleiter (3) auf einem auf der Leiterbahn (1) befestigten Isolator (10) aufgebracht ist.

4. Einrichtung nach Anspruch 3, **dadurch gekennzeichnet, daß** der Isolator (10) aus Keramik besteht.

5. Einrichtung nach Anspruch 3 oder 4, **dadurch gekennzeichnet, daß** eine Kupferbeschichtung der Unterseite des Isolators (10) mit der Leiterbahn (1) verlötet ist.

6. Einrichtung nach Anspruch 1 oder 2, **dadurch gekennzeichnet, daß** der Meßleiter (3) von einer Isolierschicht (12) umgeben ist.

7. Einrichtung nach einem der Ansprüche 1 bis 6, **dadurch gekennzeichnet, daß** in der Nähe der Leiterbahn (1) ein Temperaturfühler (27) angeordnet ist, der mit einer Steuervorrichtung (20) eines Leistungsteils (18) verbunden ist, die den Leistungsteil in Abhängigkeit von einem Meßwert eines Verbraucherstroms (I) steuert und mit einem Speicher (22) in Austauschverbindung steht, daß ein Korrekturfaktor (K_{H}), der der Abweichung des ohmschen Widerstands des Meßabschnitts (2) von einem vorbestimmten Nennwert entspricht, im Speicher (22) gespeichert ist und daß die Steuervorrichtung (20) jeden Meßwert des durch die Leiterbahn (1) fließenden Verbraucherstroms (I) mit dem Korrekturfaktor multipliziert.

8. Einrichtung nach Anspruch 7, **dadurch gekennzeichnet, daß** der Korrekturfaktor (K_{H}) die Abhängigkeit des ohmschen Widerstands des Meßabschnitts (2) von einer vorbekannten Herstellungs-Maßtoleranz des Querschnitts des Meßabschnitts (2) berücksichtigt.

9. Einrichtung nach Anspruch 7 oder 8, **dadurch gekennzeichnet, daß** ein zweiter Korrekturfaktor (K_{T}) die Abhängigkeit des ohmschen Widerstandes des Meßabschnitts (2) von der Temperatur berücksichtigt.

10. Einrichtung nach einem der Ansprüche 1 bis 9, **dadurch gekennzeichnet, daß** bei einem pulsierenden, eine Welligkeit aufweisenden Strom (I) der Meßwert während einer Impulsflanke, vorzugsweise in deren Mitte, abgetastet wird.

11. Anwendung der Einrichtung nach einem der vorhergehenden Ansprüche in einem Leistungsmodul.

## Claims

1. Device for measuring an electrical current (I) that flows through a strip conductor (1), with an essentially currentless measuring conductor (3) extending in the flow direction of the current, along and in the proximity of a rectilinear measuring section (2) of the strip conductor, one end of the measuring conductor being electrically connected with one end of the measuring section (2), the other end of the measuring section being provided with a first measuring point (4), and with a second measuring point (5) being electrically connected with the other end of the measuring section (2), the second measuring point (5) being connected directly with the measuring section (2), so that, as measure of the current (I) to be measured, a voltage (U) is taken from the measuring points (4, 5), **characterised in that** the measuring conductor (3) is located outside the plane of the strip conductor (1) and that the measuring conductor (3) is electrically connected with the strip conductor (1) by means of a wire (11) and further is mounted to be electrically isolated from the strip conductor.

2. Device according to claim 1, **characterised in that** the measuring conductor (3) extends into the immediate proximity of the connecting spot of the measuring section (2) and the second measuring point (5).

3. Device according to claim 1 or 2, **characterised in that** the measuring conductor (3) is arranged on an insulator (10) fixed on the strip conductor (1).

4. Device according to claim 3, **characterised in that** the insulator (10) is made of ceramic.

5. Device according to claim 3 or 4, **characterised in that** a copper layer on the bottom side of the insulator (10) is brazed onto the strip conductor (1).

6. Device according to claim 1 or 2, **characterised in that** the measuring conductor (3) is surrounded by an insulating layer (12).

7. Device according to one of the claims 1 to 6, **characterised in that** a temperature sensor (27) is located near the strip conductor (1), said temperature sensor (27) being connected with a control device (20) of a power unit (18), which controls the power unit in dependence of a measured value of a load current (I), and communicating with a memory (22), that a correction factor (K_{H}), which corresponds to the deviation of the ohmic resistance of the measuring section (2) from a predetermined nominal value, is stored in the memory (22), and that the control device (20) multiplies each measured value of the load current (I) flowing through the strip conductor (1) by the correction factor.

8. Device according to claim 7, **characterised in that** the correction factor (K_{H}) compensates the dependence of the ohmic resistance of the measuring section (2) on a known manufacturing measurement tolerance of the cross-section of the measuring section (2).

9. Device according to claim 7 or 8, **characterised in that** a second correction factor (K_{T}) compensates the dependence of the ohmic resistance of the measuring section (2) on the temperature.

10. Device according to one of the claims 1 to 9, **characterised in that** with a pulsating current (I) having a ripple, the measuring value is sampled during a pulse flank, preferably in its middle.

11. The use of the device according to one of the preceding claims in a power module.

## Revendications

1. Dispositif pour la mesure d'un courant (1) électrique circulant dans une piste conductrice (1), comprenant un conducteur de mesure (3) s'étendant dans le sens de flux du courant le long et à proximité d'un tronçon de mesure (2) rectiligne de la piste conductrice et largement sans courant, dont une extrémité est électriquement reliée directement à une extrémité du tronçon de mesure (2) et dont l'autre extrémité est pourvue d'une première prise de valeur de mesure (4), et une seconde prise de valeur de mesure (5), qui est relié électriquement à l'autre extrémité du tronçon de mesure (2), la seconde prise de valeur de mesure (5) étant reliée directement au tronçon de mesure (2), de sorte qu'une tension (U) est prélevée sur les prises de valeur de mesure (4, 5) comme référence pour le courant (I) à mesurer, **caractérisé en ce que** le conducteur de mesure (3) est appliqué à l'extérieur du plan de la piste conductrice (1), et **en ce que** le conducteur de mesure (3) est relié électriquement à la piste conductrice (1) par une ligne (11) et est appliqué du reste dans l'isolation électrique de la piste conductrice.

2. Dispositif selon la revendication 1, **caractérisé en ce que** le conducteur de mesure (3) s'étend jusqu'à proximité immédiate du point de liaison du tronçon de mesure (2) et de la seconde prise de valeur de mesure (5).

3. Dispositif selon la revendication 1 ou 2, **caractérisé en ce que** le conducteur de mesure (3) est appliqué sur un isolateur (10) fixé sur la piste conductrice (1).

4. Dispositif selon la revendication 3, **caractérisé en ce que** l'isolateur (10) est en céramique.

5. Dispositif selon la revendication 3 ou 4, **caractérisé en ce qu'**un revêtement de cuivre du côté inférieur de l'isolateur (10) est soudé avec la piste conductrice (1).

6. Dispositif selon la revendication 1 ou 2, **caractérisé en ce que** le conducteur de mesure (3) est entouré d'une couche isolante (12).

7. Dispositif selon l'une quelconque des revendications 1 à 6, **caractérisé en ce qu'**à proximité de la piste conductrice (1) est disposée une sonde de température (27), qui est reliée à un dispositif de commande (20) d'une partie de puissance (18) qui commande la partie de puissance en fonction d'une valeur de mesure d'un courant utilisateur (1) et est en liaison d'échange avec une mémoire (22), **en ce qu'**un facteur de correction (K_{H}), qui correspond à l'écart entre la résistance ohmique du tronçon de mesure (2) et une valeur nominale prédéfinie, est mémorisé dans la mémoire (22) et **en ce que** le dispositif de commande (20) multiplie chaque valeur de mesure du courant utilisateur circulant dans la piste conductrice (1) par le facteur de correction.

8. Dispositif selon la revendication 7, **caractérisé en ce que** le facteur de correction (K_{H}) tient compte de la dépendance entre la résistance ohmique du tronçon de mesure (2) et la tolérance de mesure de fabrication déjà connue de la section du tronçon de mesure (2).

9. Dispositif selon la revendication 7 ou 8, **caractérisé en ce qu'**un second facteur de correction (K_{T}) tient compte de la dépendance entre la résistance ohmique du tronçon de mesure (2) et la température.

10. Dispositif selon l'une quelconque des revendications 1 à 9, **caractérisé en ce que**, avec un courant (I) pulsé et présentant une ondulation, la valeur mesurée est balayée pendant un flanc d'impulsion, de préférence en son centre.

11. Utilisation du dispositif selon l'une quelconque des revendications précédentes dans un module de puissance.
